Europäisches Patentamt

European Patent Office

Office européen des brevets

(11) Veröffentlichungsnummer: **0 466 202 A1**

# (12) EUROPÄISCHE PATENTANMELDUNG

(21) Anmeldenummer: **91114359.2**

(22) Anmeldetag: **11.09.89**

(51) Int. Cl.5: **H05K 3/06**, C23F 1/02

Diese Anmeldung is am 27 - 08 - 1991 als Teilanmeldung zu der unter INID-Kode 60 erwähnten Anmeldung eingereicht worden.

(30) Priorität: **29.09.88 DE 3833094**

(43) Veröffentlichungstag der Anmeldung:
**15.01.92 Patentblatt 92/03**

(60) Veröffentlichungsnummer der früheren Anmeldung nach Art. 76 EPÜ: **0 361 192**

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Mattelin, Antoon**
**Leliestraat 6**
**B-8020 Oostkamp(BE)**

(54) **Verfahren zur Herstellung von Leiterplatten.**

(57) Auf ein Substrat (1) werden nacheinander eine Metallschicht (4) und eine metallische Ätzresistschicht (5) aufgebracht, worauf diese Ätzresistschicht (5) mittels elektromagnetischer Strahlung, vorzugsweise mittels Laserstrahlung, in den unmittelbar an das spätere Leiterbahnmuster angrenzenden Bereichen entfernt und die dadurch freigelegte Metallschicht (4) weggeätzt wird. Die Strukturierung mittels elektromagnetischer Strahlung kann rasch vorgenommen werden, da die größeren Flächen zwischen den Leiterbahnen stehen bleiben.

FIG5

EP 0 466 202 A1

Die Erfindung betrifft ein verfahren zur Herstellung von Leiterplatten, bei welchem eine ganzflächig auf eine Metallschicht aufgebrachte metallische Ätzresistschicht mittels elektromagnetischer Strahlung selektiv wieder entfernt wird und das Leiterbahnmuster durch Abätzen der derart freigelegten Metallschicht strukturiert werden kann.

Ein derartiges Verfahren geht beispielsweise aus der EP-A-0 062 300 hervor. Um bei diesem bekannten verfahren die Metallschicht zwischen den Leiterbahnen durch Ätzen vollständig entfernen zu können, muß zuvor die darüberliegende Ätzresistschicht ebenfalls vollständig entfernt werden. Diese Entfernung der Ätzresistschicht, die vorzugsweise in einem Scanverfahren mit dem Laser vorgenommen werden soll, ist jedoch aufwendig und zeitraubend. Dies trifft insbesondere dann zu, wenn die Leiterbahnen relativ weit auseinander liegen und die Flächen der mit dem Laser abzutragenden Ätzresistschicht somit relativ groß sind.

Der Erfindung liegt die Aufgabe zugrunde, das bekannte Verfahren zur Herstellung von Leiterplatten so zu verbessern, daß die selektive Entfernung der metallischen Ätzresistschicht mittels elektromagnetischer Strahlung rasch und mit geringem Aufwand vorgenommen werden kann.

Die Lösung dieser Aufgabe erfolgt durch folgende Verfahrensschritte:

a) auf ein elektrisch isolierendes Substrat werden nacheinander eine Metallschicht und eine metallische Ätzresistschicht aufgebracht;

b) die Ätzresistschicht wird in den unmittelbar an das spätere Leiterbahnmuster angrenzenden Bereichen mittels elektromagnetischer Strahlung wieder entfernt;

c) die im Schritt b) freigelegten Bereiche der Metallschicht werden bis zur Oberfläche des Substrats weggeätzt.

Bei dem erfindungsgemäßen Verfahren werden also im Unterschied zu der bisherigen Vorgehensweise nur die unmittelbar an das spätere Leiterbahnmuster angrenzenden Bereiche der Ätzresistschicht mittels elektromagnetischer Strahlung entfernt. Die Konturbeschreibung mittels der elektromagnetischer Strahlung ist also als eine enge Umfahrung des Leiterbahnmusters anzusehen, die im Hinblick auf die geringe Flächenausdehnung der abzutragenden Ätzresistschicht rasch vorgenommen werden kann.

Gemäß einer bevorzugten Ausgestaltung des erfindungsgemäßen Verfahrens ist vorgesehen, daß nach dem im Schritt c) vorgenommenen Wegätzen die Ätzresistschicht vollständig entfernt wird.

Gemäß einer weiteren bevorzugten Ausgestaltung des erfindungsgemäßen Verfahrens ist vorgesehen, daß die Metallschicht durch stromlose und galvanische Abscheidung von Kupfer auf das Substrat aufgebracht wird. Diese Vorgehensweise ist insbesondere dann von Vorteil, wenn Leiterplatten mit Durchkontaktierungen hergestellt werden sollen und durch die stromlose und galvanische Abscheidung von Kupfer auch eine Metallisierung der entsprechenden Durchkontaktierungslöcher erzielt wird.

Es hat sich weiterhin als besonders günstig erwiesen, wenn für die Ätzresistschicht Zinn oder eine Zinn-Blei-Legierung verwendet wird. Derartige Ätzresistschichten lassen sich einerseits beispielsweise mit einem Laser leicht strukturieren, während sie andererseits beim Ätzen einen sicheren Schutz der darunterliegenden Metallschicht gewährleisten.

Die Ätzresistschicht wird vorzugsweise durch stromlose Metallabscheidung aufgebracht, da dies auf besonders wirtschaftliche Weise durchgeführt werden kann und dabei auch ein sicherer Schutz der Metallschicht innerhalb der Durchkontaktierungen erzielt wird.

Die elektromagnetische Strahlung wird vorzugsweise durch einen Laser erzeugt, da Laserstrahlen für ein Abtragen bzw. Verdampfen der Ätzresistschicht in den erwünschten Bereichen besonders geeignet sind. Die Bewegung des Laserstrahls relativ zum Substrat sollte dann vorzugsweise frei programmierbar sein, d.h., daß eine Konturbeschreibung des Leiterbahnmusters mit dem Laserstrahl rasch durchgeführt und insbesondere auch leicht variiert werden kann.

Im Hinblick auf eine weitere Steigerung der Wirtschaftlichkeit des erfindungsgemäßen Verfahrens ist es auch besonders günstig, wenn ein dreidimensionales, spritzgegossenes Substrat mit eingespritzten Durchkontaktierungslöchern verwendet wird. Derartige Substrate können dann durch Spritzgießen in großer Anzahl wirtschaftlich gefertigt werden, während die dreidimensionale Ausgestaltung der Substrate bzw. Leiterplatten bei einer Strukturerzeugung mittels elektromagnetischer Strahlung kein Problem darstellt.

Ein Ausführungsbeispiel der Erfindung ist in der Zeichnung dargestellt und wird im folgenden näher beschrieben.

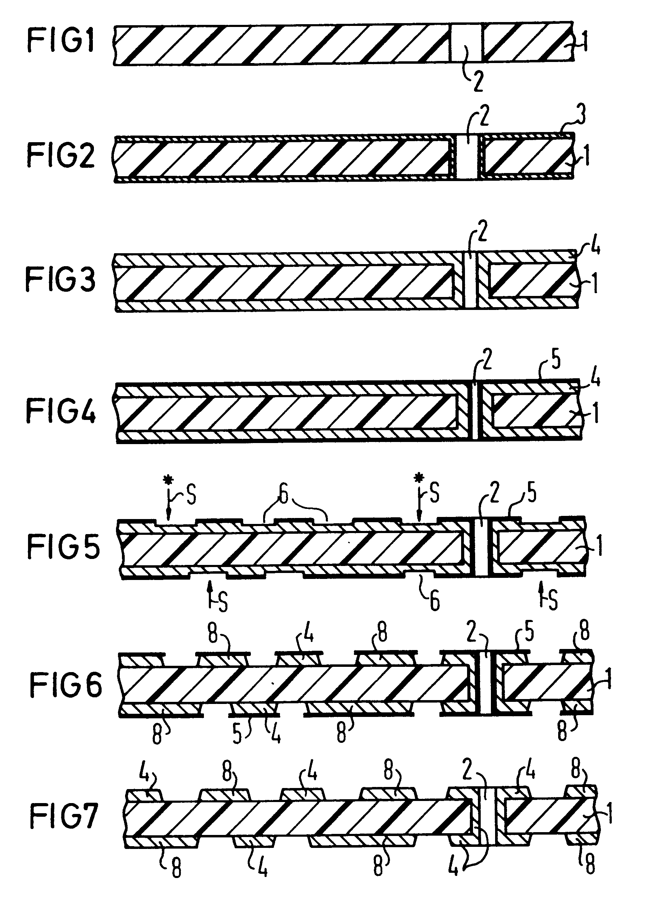

Die Figuren 1 bis 7 zeigen in stark vereinfachter schematischer Darstellung die verschiedenen Verfahrensstadien bei der Herstellung von Leiterplatten nach der Erfindung.

Bei dem in Fig. 1 dargestellten Substrat 1 handelt es sich um einen Ausschnitt eines Basismaterials mit eingespritzten Durchkontaktierungslöchern 2. Als Materialien für die Substrate derartiger Leiterplatten sind insbesondere hochtemperaturbeständige Thermoplaste geeignet, wobei im geschilderten Ausführungsbeispiel glasfaserverstärktes Polyetherimid verwendet wurde.

Das in Fig. 1 dargestellte Substrat 1 wurde zunächst zur Erhöhung der Haftfestigkeit der später aufzubringenden Leiterbahnen und Durchkontaktierungen gebeizt und anschließlich gereinigt. Dabei wurden sowohl für das Beizen als auch für die Reinigung des Substrats 1 handelsübliche Bäder verwendet, wobei das Beizbad speziell auf den Werkstoff Polyetherimid abgestimmt war.

Nach dem Beizen und Reinigen des Substrats 1 erfolgte dessen Bekeimung, die in Fig. 2 als dünne Schicht 3 aufgezeigt ist. Es ist ersichtlich, daß die Bekeimung 3 auf die Oberfläche des Substrats 1 und auf die Wandungen der Durchkontaktierungslöcher 2 aufgebracht wurde. Das Aufbringen der Bekeimung 3 erfolgte durch Eintauchen des Substrates 1 in ein $PdCl_2$-$SnCl_2$-Bad. Für das Aufbringen der Bekeimung 3 haben sich aber auch handelsübliche Bäder auf der Basis palladiumorganischer Verbindungen als geeignet erwiesen.

Nach dem Aufbringen der Bekeimung 3 wird diese aktiviert, wobei es sich hier um ein in der Additivtechnik übliches Reduzieren bzw. Beschleunigen handelt. Anschließend wurde gemäß Fig. 3 durch außenstromlose chemische Metallabscheidung eine äußerst dünne Schicht aufgebracht. Es ist ersichtlich, daß auch diese in einem handelsüblichen stromlosen Kupferbad aufgebrachte Grundschicht die Oberfläche des Substrats 1 und die Wandungen der Durchkontaktierungslöcher 2 überzieht.

Anschließend wird vollflächig stromlos verkupfert und galvanisch mit Kupfer verstärkt wodurch insgesamt eine Metallschicht 4 entsteht, die beispielsweise eine Stärke von 30 Mikrometern aufweist.

Gemäß Fig. 4 wird dann auf die Metallschicht 4 durch stromlose Metallabscheidung eine Ätzresistschicht 5 aufgebracht, die im beschriebenen Ausführungsbeispiel aus Zinn besteht.

Gemäß Fig. 5 wird die Ätzresistschicht 5 dann mit Hilfe eines Nd-YAG-Lasers in einem Scanverfahren strukturiert, wobei die Strahlung durch Pfeile S lediglich angedeutet ist. Es ist zu erkennen, daß die Entfernung der Ätzresistschicht 5 auf die unmittelbar an das spätere Leiterbahnmuster angrenzenden Bereiche 6 begrenzt ist.

Nach der geschilderten selektiven Entfernung der Ätzresistschicht 5 werden die hierbei freigelegten Bereiche der Metallschicht 4 durch Ätzen entfernt, wobei hierfür in der Subtrakivtechnik übliche Ätzlösungen eingesetzt werden können. Fig. 6 zeigt, daß bei diesem Ätzschritt das Leiterbahnmuster bereits entsteht, wobei zwischen den Leiterbahnen Bereiche 8 der Metallschicht 4 verblieben sind.

Aus Fig. 7 ist das Strippen der Ätzresistschicht 5 ersichtlich.
8 Patentansprüche
7 Figuren

**Patentansprüche**

1. Verfahren zur Herstellung von Leiterplatten, mit folgenden Verfahrensschritten:
    a) auf ein elektrisch isolierendes Substrat (1) werden nacheinander eine Metallschicht (4) und eine metallische Ätzresistschicht (5) aufgebracht;
    b) die Ätzresistschicht (5) wird in den unmittelbar an das spätere Leiterbahnmuster angrenzenden Bereichen (6) mittels elektromagnetischer Strahlung (S) wieder entfernt;
    c) die im Schritt b) freigelegten Bereiche der Metallschicht (4) werden bis zur Oberfläche des Substrats (1) weggeätzt;

2. Verfahren nach Anspruch 1,
    **dadurch gekennzeichnet,**
    daß nach dem im Schritt c) vorgenommenen Ätzen die Ätzresistschicht (5) vollständig entfernt wird.

3. Verfahren nach Anspruch 1 oder 2,
    **dadurch gekennzeichnet,**
    daß die Metallschicht (4) durch stromlose und galvanische Abscheidung von Kupfer auf das Substrat (1) aufgebracht wird.

4. Verfahren nach einem der vorhergehenden Ansprüche,
    **dadurch gekennzeichnet,**
    daß für die Ätzresistschicht (5) Zinn oder eine Zinn-Blei-Legierung verwendet wird.

5. Verfahren nach einem der vorhergehenden Ansprüche,
    **dadurch gekennzeichnet,**
    daß die Ätzresistschicht (5) durch stromlose Metallabscheidung aufgebracht wird.

6. Verfahren nach einem der vorhergehenden Ansprüche,
    **dadurch gekennzeichnet,**
    daß die elektromagnetische Strahlung (S) durch einen Laser erzeugt wird.

7. Verfahren nach Anspruch 6,
    **dadurch gekennzeichnet,**
    daß die Bewegung des Laserstrahls relativ zum Substrat (1) frei programmierbar ist.

8. Verfahren nach einem der vorhergehenden Ansprüche,
    **dadurch gekennzeichnet,**
    daß ein dreidimensionales, spritzgegossenes Substrat (1) mit eingespritzten Durchkontaktierungslöchern (2) verwendet wird.

FIG1

FIG2

FIG3

FIG4

FIG5

FIG6

FIG7

# Europäisches Patentamt

## EUROPÄISCHER RECHERCHENBERICHT

Nummer der Anmeldung

**EP 91 11 4359**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | EP-A-0 062 300 (FRITZ WITTIG HERSTELLUNG GE-DRUCKTER SCHALTUNGEN) <br> * Seite 4; Ansprüche 1,2 * * <br> – – – | 1,2,4,6,7 | H 05 K 3/06 <br> C 23 F 1/02 |
| Y | DE-A-3 245 272 (ERNST ROEDERSTEIN SPEZIALFABRIK FUR KONDENSATOREN) <br> * Seite 4, letzter Absatz - Seite 5, Absatz 1 * * <br> – – – | 1,2,4,6,7 | |
| A | FR-A-2 079 613 (R.T.C. LA RADIOTECHNIQUE- COMPE-LEC) <br> * Seite 3, Zeile 23 - Zeile 34 * * * Seite 5, Zeile 10 - Zeile 35 * * <br> – – – | 1,3,4 | |
| A | US-E-30 434 (DAVIS) <br> * Spalte 1, Zeile 10 - Zeile 37 * * <br> – – – – – | 4,5 | |

### RECHERCHIERTE SACHGEBIETE (Int. Cl.5)

H 05 K
C 23 F
C 23 C

Der vorliegende Recherchenbericht wurde für alle Patentansprüche erstellt

| Recherchenort | Abschlußdatum der Recherche | Prüfer |
|---|---|---|
| Den Haag | 18 Oktober 91 | MES L.A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

-----------------------------------------------------------

& : Mitglied der gleichen Patentfamilie, übereinstimmendes Dokument